Europäisches Patentamt

European Patent Office

Office européen des brevets

(11) Publication number : **0 509 732 A2**

(12) **EUROPEAN PATENT APPLICATION**

(21) Application number : **92303277.5**

(22) Date of filing : **13.04.92**

(51) Int. Cl.⁵ : **H01L 21/60, H01L 23/367**

(30) Priority : **15.04.91 JP 108148/91**

(43) Date of publication of application :
**21.10.92 Bulletin 92/43**

(84) Designated Contracting States :
**DE FR GB**

(71) Applicant : **International Business Machines Corporation**
**Old Orchard Road**
**Armonk, N.Y. 10504 (US)**

(72) Inventor : **Nakama, Sunao**
**10-17 Hotarudani**
**Ohtsu-shi, Shiga-ken (JP)**
Inventor : **Tsuchida, Shuhei**
**8-16-1 Kamigasa 3-chome**
**Kusatsu-shi, Shiga-ken (JP)**

(74) Representative : **Blakemore, Frederick Norman**
**IBM United Kingdom Limited Intellectual Property Department Hursley Park**
**Winchester Hampshire SO21 2JN (GB)**

(54) **Semiconductor device attached on a substrate.**

㉗ A semiconductor chip 4 is attached to a ground plane layer 2 on a substrate 1 by a face down method through solder balls 7. A heat transfer material 5 attached to the ground plane layer 2 is in thermal contact with the semiconductor chip through a flexible heat transfer layer 9. The heat from the semiconductor chip is radiated by a large area by using the ground plane layer. The semiconductor chip and the heat transfer material are in contact with each other in a relatively movable state, to prevent that the thermal stresses from the substrate being exerted on the semiconductor chip.

FIG. 1

**EP 0 509 732 A2**

The invention relates to semiconductor devices having a cooling structure for a semiconductor chip provided on a substrate and, more particularly, to a cooling structure in which the heat from a semiconductor chip is transferred to a ground plane layer provided on a substrate and is then radiated.

As the degree of integration of semiconductor chips rises and the power also increases, the cooling structure of the semiconductor chip becomes increasingly important. Hitherto, the cooling structure has been mainly either of the type in which the heat generated in a semiconductor chip is transferred to the substrate side and the semiconductor chip is cooled, or of the type in which heat radiation fins are connected to the semiconductor chip and the heat is radiated into the air or the like.

Regarding methods of cooling the semiconductor chip by transferring the heat to the substrate side, the following structures are known in the prior art.

In JP-A-2-77142 or JP-A-64-24446, there is disclosed a structure in which a dent is formed in a substrate having therein a ground potential layer or a power source potential layer to thereby expose the ground potential layer or the power source potential layer, a semiconductor chip is fixed onto the ground potential layer or power source potential layer by an adhesive agent or a solder, and the heat from the semiconductor chip is radiated to the ground potential layer or power source potential layer, thereby cooling the chip.

In the above structure, however, the semiconductor chip is installed by a wire bonding method whereby, on the surface opposite to the fixed surface, the semiconductor chip is connected to signal lines on the substrate by lead wires. Since the semiconductor chip is fixed to the lead wires and the ground potential layer and the like by the upper and lower surfaces, stresses are applied to the connecting portions of the lead wires and the chip itself by thermal stresses from the substrate side.

In JP-A-61-58297, there is disclosed a structure in which heat radiation pads provided on a substrate are in contact with the bottom surface of a semiconductor chip attached to the substrate and the heat is diffused to a ground potential layer provided in the substrate through the radiation pads, thereby cooling the chip.

In this structure, however, since the attaching surface of the semiconductor chip to the substrate and the contact surface with the radiation pads are the same, the attaching structure of the semiconductor chip becomes complicated and it is difficult to obtain a sufficiently large contact area with the heat radiation pads.

Regarding methods of radiating the heat into the air or the like from radiation fins, the following structures are known in the prior art.

In JP-A-63-90843 and JP-A-58-92241, there are disclosed structures in which a semiconductor chip attached onto a substrate is covered by a package cap having heat radiation fins which are vertically formed on the outer surface. The inner surface of the package cap is fixed or is thermally in contact with the upper surface of the semiconductor chip, thereby radiating the heat from the semiconductor chip into the air from the radiation fins.

In JP-A-64-24447, a structure in which radiation fins are dipped into a water cooled jacket and a chip is cooled by cooling water is disclosed.

In both of the above structures the package cap structure is not adapted to transfer the heat to the substrate, and the heat radiation is accomplished by the heat radiation from the radiation fins. Therefore the radiation fins must be relatively big and the cooling structure rather large.

In JP-A-63-208250, there is disclosed a structure such that a metallic package cap is adhered to a semiconductor chip attached onto a substrate, thereby covering the chip. The above structure, however, intends to accurately set the attaching position of the package cap to the substrate. A construction to perform the heat conduction from the package cap to the substrate is not disclosed.

In JP-A-2-94535, a structure in which wirings made of silver paste are connected to the upper surface of a semiconductor chip attached onto a substrate is disclosed. The wirings, however, intend to electrically connect the semiconductor chip to the circuit wirings on the substrate and do not perform the heat conduction.

It is an object of the invention to minimise the size of a cooling structure without subjecting the semiconductor chip to undue stress.

Accordingly the invention provides a semiconductor device comprising a substrate, a semiconductor chip attached on a first surface to the substrate, and a cooling structure in thermal contact with a second surface of the semiconductor chip for transferring heat from the semiconductor chip to a ground plane layer on the substrate, characterised in that at least part of the cooling structure is movable relative to said second surface of the semiconductor chip so as to prevent the cooling structure transferring thermal stress from the first surface of the semiconductor to the second surface.

Despite a reduction in size of the cooling structure, the ground plane layer for the supply of a ground potential or a power source potential provides sufficient heat radiation onto the substrate. Furthermore, although a heat transfer path to the ground plane layer is provided, the ability for relative movement ensures that thermal stresses on the substrate side do not exert any influence on the semiconductor chip side. This arrangement miniaturises the cooling structure, allows relative movement of the heat transfer material and the semiconductor chip, and prevents thermal stresses from the substrate side being transferred to the semiconductor chip side.

Typically, the cooling structure which is attached at one end to the ground plane layer on the substrate is thermally in contact with the semiconductor chip via a layer of deformable heat transfer material. The heat transfer material and the semiconductor chip are relatively movable. Heat is transferred from the semiconductor chip to the ground plane layer on the substrate through the heat transfer material and heat dissipation is promoted. Thus the semiconductor chip comes into thermal contact with the cooling structure in a relatively movable state through a heat transfer layer such as a thermal grease or the like which can be freely deformed and whose heat conductivity is high. This has advantages as regards the dimensional precision between the semiconductor chip and the heat transfer material, since the surface matching properties therebetween are made gentle.

Alternatively it is possible for the cooling structure to be fixed directly to the chip, and the cooling structure itself to be at least partly flexible. In a manner similar to the above, this reduces the size of the cooling structure by promoting heat dissipation by transferring heat from the semiconductor chip to the ground plane layer on the substrate whilst still preventing thermal stresses from the substrate side being transferred to the semiconductor chip side. Another possibility is for the cooling structure to be directly in contact with the chip, but not fastened to it, so as to allow relative sliding movement between the two.

The substrate preferably made of a material of a high heat conductivity to improve cooling efficiency. From a similar viewpoint, it is preferabe that the ground plane layer is a ground potential layer which is on the surface of the substrate so as to have a relatively large exposed area. However, the ground potential layer could also be inside the substrate and even limited in extent, provided sufficient heat dissipation could be achieved. It is also possible for the ground plane layer to provide a power source potential.

From a viewpoint of protection of the semiconductor chip. It is desirable that the heat transfer material is a cap which covers the semiconductor chip. It is further preferable that the cap is made of a metal.

From a viewpoint to simplify the structure and to assure a large enough contact area between the semiconductor chip and the cooling structure, it is preferable that the semiconductor chip is attached to the ground plane layer by a face down so such that the device forming surface faces the substrate. Thus the cooling structure does not adversely affect the amount of space on the chip available for signal connections, and vice versa.

Embodiments of the invention will be described by way of example based on the drawings:

Fig. 1 is a cross sectional view showing a semiconductor device with cooling structure according to one embodiment of the invention.

Fig. 2 is a plan view showing the semiconductor device of Figure 1 without the cooling structure cap.

Fig. 3 is a cross sectional view showing a semiconductor device with cooling structure according to another embodiment of invention.

As shown in the diagrams, a ground plane layer 2 having a predetermined pattern is formed on a substrate 1. A solder resist layer 3 is formed on the surface of the ground plane layer 2 and a passivation is performed. A predetermined patterning is performed to the solder resist layer 3. The ground plane layer 2 is exposed in an area for bonding a semiconductor chip 4 and an area 6 to join a cap 5 as a heat transfer material.

In the embodiment, the ground plane layer 2 is a ground potential layer which is formed as a plane on almost the whole area of the surface of the multi-layer substrate 1 having therein a wiring layer 10. With such a multi-layer structure for the substrate 1, the wiring density is improved and the wiring layer is protected from disturbance. Although the ground plane layer 2 can be also set to a power source potential layer, in such a case, it is necessary to take a countermeasure to prevent charging the heat transfer material, as described later, or the like.

The semiconductor chip 4 is attached to the substrate 1 by a controlled collapse chip connector method such as a flip chip method in a down face state. The semiconductor chip 4 is attached to the substrate 1 through solder balls 7 joined to an electrode pad of the semiconductor chip 4 and the ground plane layer 2 on the substrate 1 and is also electrically connected to a ground potential or a power source potential.

In the embodiment, wirings 10 for input/output to-/from the semiconductor chip 4 or for control thereof are formed in the substrate 1 at a layer lower than the ground plane layer 2. The semiconductor chip 4 is also connected to the wirings 10 through solder balls (not shown).

The cap 5 is attached to the substrate 1 in a state in which it covers the semiconductor chip 4. Four corners of the cap 5 are joined to the ground plane layer 2 in region 6 by solders 8, thereby thermally connecting and fixing the cap 5 to the ground plane layer 2.

In the embodiment, the cap 5 is made of a metal of a high heat conductivity having dimensions such that a gap is formed between the inside surface of the cap 5 to thermally come into contact with the semiconductor chip 4 in a relatively movable state.

In the embodiment, the heat transfer material layer 9 is a layer made of a thermal grease. The thermal grease is filled between the cap 5 and the semiconductor chip 4 without a gap, thereby allowing the semiconductor chip 4 to thermally come into contact with the cap 5 in a state of low thermal resistance due to the high heat conductivity of the thermal grease itself.

Since the heat transfer material layer 9 is deformable, relative movement between the cap 5 and the semiconductor chip 4 is allowed, thereby preventing thermal stresses being transferred from the substrate side to the cap side of the semiconductor chip.

According to the cooling structure of the above construction, the heat generated in the semiconductor chip 4 is transferred to the ground plane layer 2 through the solder balls 7 and is radiated. Heat is also transferred to the cap 5 through the thermal grease 9 and is dissipated by heat radiation from the cap 5 and conduction to the ground plane layer 2. Therefore, a high heat radiating effect can be obtained by the ground plane layer 2 having a relatively wide area without having to form radiation fins on portions around the semiconductor chip. The semiconductor chip 4 can therefore be effectively cooled without enlarging the cooling structure.

Although thermal stresses are generated on the basis of a difference of the coefficients of thermal expansion of the substrate 1 and the semiconductor chip 4, the influence of the thermal stresses from the substrate side does not extend across the semiconductor chip owing to the gap filled with thermal grease 9. No excessive stress is applied to the semiconductor chip. Consequently, the occurrence of cracks in the semiconductor chip and damage to the joint portions of the solder balls are prevented and the durability and reliability of the apparatus are improved.

In order to absorb a dimensional error between the semiconductor chip and the heat transfer material and to absorb the thermal stresses from the substrate side, it is preferable that the heat transfer material layer 9 is a semifluid material such as a thermal grease having a high heat conductivity.

According to the invention, in order to reduce heat resistance further, the cap 5 can also directly come into contact with the semiconductor chip 4 in a relatively movable state without forming a gap between the semiconductor chip 4 and the cap 5. In such a case as well, since relative movement is permitted between them, the generation of thermal stresses in a direction parallel with the surface of the substrate 1 is prevented. Particularly, the generation of stresses in the shearing direction, a direction in which the structure of the solder ball joining portion is weak, can be prevented.

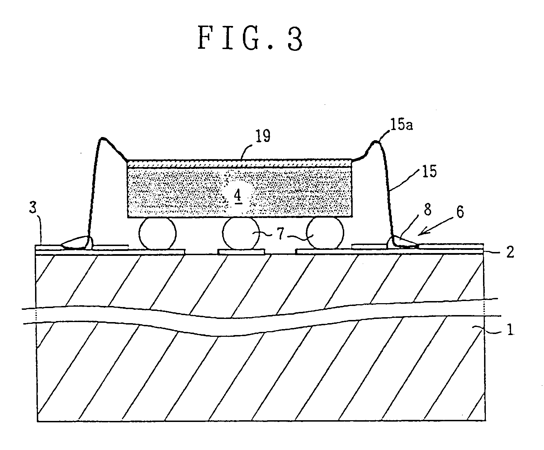

Fig. 3 is a cross sectional view of another preferred embodiment with cooling structure, the same portions as those in the above embodiment being designated by the same reference numerals.

In the embodiment, a cap 15 acting as a heat transfer material is made of a thin metal plate. A shoulder portion 15a of the cap 15 is formed in a projecting curved shape like a circle, thereby providing sufficient flexibility to prevent thermal stresses as before. The semiconductor chip 4 is fixed to the cap 15 by an adhesive agent 19 of a high heat conductivity and relative movement between the cap 15 and the semiconductor chip 4 is not permitted. Other aspects are similar to those in the foregoing embodiment.

According to the cooling structure of the above construction, the heat generated by the semiconductor chip 4 is transferred to the cap 15 through the adhesive agent layer 19 and is radiated by the cap 15 and is also dissipated by the conduction to the ground plane layer 2. Although thermal stresses are generated on the basis of a difference of the coefficients of thermal expansion between the substrate 1 and the semiconductor chip 4, since the cap 15 is relatively easily deformable, the influence of the thermal stress from the substrate side does not extend across the semiconductor chip. No excessive stress is applied to the semiconductor chip.

For instance, a silicone rubber adhesive agent (trade name: TSE 3380, heat conductivity: 0.004 cal/cm, Sec, *C) is used as an adhesive agent 19. However, a range of various other adhesive agents are also effective in practice.

To provide sufficient flexibility, various modifications can be applied to the cap 15 in a manner such that it is formed by a wave-shaped metal plate. Alternatively, when the material itself can provide sufficient flexibility, there is no need for any special device shape.

On the other hand, a fixing method between the semiconductor chip 4 and the heat transfer material 15 is not limited to the adhesive agent but various fixing means such that they are mechanically fixed and the like can be used.

As a ground plane layer 2 to which the cap 5 or 15 is connected, it is desirable to form the ground plane layer 2 from copper having a high heat conductivity in order to efficiently absorb the heat and to obtain the heat dissipation over a wide range of the layer 2, but other various kinds of materials are also suitable.

In each of the above embodiments, as a substrate 1, it is preferable to use a substrate made of alumina whose heat conductivity is relatively high in order to also obtain a radiating effect of the heat from the substrate. However the invention does not deny the use of other various kinds of materials.

It is preferable that the ground plane layer to which the cap 5 or 15 is connected is provided on the surface side of the substrate by a wide area in order to improve the radiating performance. However, in the case where enough heat radiating effect is derived from the substrate itself, the ground plane layer is not necessarily located on the surface side of the substrate.

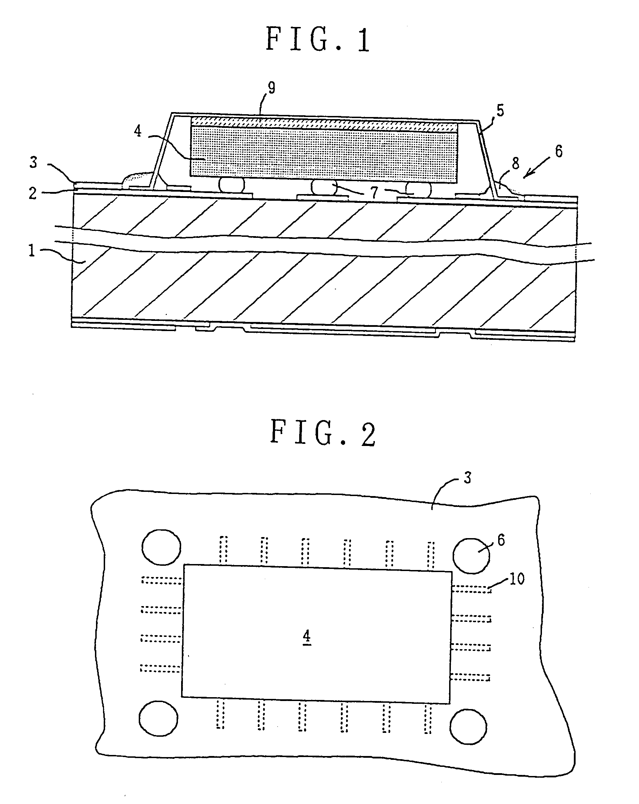

It is preferable that the heat transfer materials 5 and 15 are formed in a cap shape so as to also protect the semiconductor chip 4 and are supported at four points as shown in Fig. 2. However, when considering the inherent function of heat conduction, the shape and supporting method are not particularly limited. For instance, the heat transfer material can be also formed like an L-shape and attached by a cantilever-like supporting method. Further, the material which is used to form the heat transfer material is also not limited so long as it has a desired heat conductivity.

Like a controlled collapse chip connector method, the invention is effective when it is applied to what is called a face down bonding method in which the surface on the side opposite to the face of the semiconductor chip faces the surface of the substrate. However, the heat radiation can be also positively accomplished by applying the invention to other bonding methods.

According to the invention, the ground plane layer provided on the substrate is used for heat radiation, thereby accomplishing the apparent miniaturization of the cooling structure and enabling the installation density to be improved. Further, by allowing the semiconductor chip to thermally come into contact with the heat transfer material in a relatively movable state or by making the heat transfer material flexible, the influence by the thermal stresses on the substrate side which is exerted on the semiconductor chip side can be also prevented by providing a heat transfer path from the semiconductor chip to the ground plane layer on the substrate. The stress life of the semiconductor chip can be prolonged and the reliability can be improved while obtaining an enough high cooling effect.

**Claims**

1. A semiconductor device comprising a substrate (1), a semiconductor chip (4) attached on a first surface to the substrate, and a cooling structure (5) in thermal contact with a second surface of the semiconductor chip for transferring heat from the semiconductor chip to a ground plane layer (2) on the substrate, characterised in that at least part of the cooling structure is movable relative to said second surface of the semiconductor chip so as to prevent the cooling structure transferring thermal stress from the first surface of the semiconductor to the second surface.

2. A semiconductor device according to claim 1 in which the cooling structure comprises a cap which covers and is in thermal contact with the surface of the semiconductor chip opposite the substrate.

3. A semiconductor device according to claim 1 or 2 in which the semiconductor chip is in thermal contact with the cooling structure via a deformable heat transfer layer (9).

4. A semiconductor device according to claim 3, in which the deformable heat transfer layer consists of thermally conducting grease.

5. A semiconductor device according to claim 1 or 2 in which the semiconductor chip is directly in contact with the cooling structure, said contact being such as to allow relative sliding movement between the semiconductor chip and the cooling structure.

6. A semiconductor device according to claim 1 or 2 in which the cooling structure is at least partly flexible.

7. A semiconductor device according to claim 6 in which the semiconductor chip is fixed to the cooling structure by an adhesive agent having a high heat conductivity.

8. A semiconductor device according to any preceding claim in which the semiconductor chip is soldered to said ground plane layer by a face down method.

9. A semiconductor device according to any preceding claim in which said ground plane layer is a ground potential layer.

10. A semiconductor device according to any preceding claim in which said ground plane layer is provided on the surface of the substrate so as to have a relatively large exposed area.

# FIG. 1

# FIG. 2

# FIG. 3